Europäisches Patentamt

European Patent Office

Office européen des brevets

(11) Veröffentlichungsnummer: **0 501 597 A2**

## (12) EUROPÄISCHE PATENTANMELDUNG

(21) Anmeldenummer: **92250039.2**

(22) Anmeldetag: **21.02.92**

(51) Int. Cl.5: **H03M 1/82**

(30) Priorität: **26.02.91 DE 4106432**

(43) Veröffentlichungstag der Anmeldung:
**02.09.92 Patentblatt 92/36**

(84) Benannte Vertragsstaaten:
**AT BE CH ES FR GB IT LI NL SE**

(71) Anmelder: **SIEMENS AKTIENGESELLSCHAFT**
**Wittelsbacherplatz 2**
**W-8000 München 2(DE)**

(72) Erfinder: **Lesche, Wolfgang**
**Wildbergweg 13**
**W-1000 Berlin 37(DE)**

(54) **Digital-Analog-Umsetzverfahren und Vorrichtung zur Durchführung des Verfahrens.**

(57) Ein umzusetzender Digitalwert (DW) wird durch ein von einer Einschaltimpulsdauer ($T_E$) zu einer Periodendauer ($T_p$) bestimmtes Tastverhältnis (n/m) dargestellt. In jeder Periode (P1, P2) wird eine Anzahl von Einzelimpulsen (E1...E7) gebildet und über die Periode (P1, P2) annähernd gleichmäßig verteilt, wobei die Summe der Einzelimpulsdauer ($t_o$) der Einschaltimpulsdauer ($T_E$) entspricht.

FIG 4

EP 0 501 597 A2

Die Erfindung bezieht sich auf ein Digital-Analog-Umsetzverfahren, bei dem ein umzusetzender Digitalwert durch ein von einer Einschaltimpulsdauer einer Periode zu deren Periodendauer bestimmtes Tastverhältnis dargestellt wird, bei dem eine Filterstufe gemäß dem Tastverhältnis mit einer Refererenzgröße beaufschlagt wird und bei dem an deren Ausgang ein Analogwert abgegriffen wird.

Bei einem derartigen bekannten ("A/D- und D/A-Wandler", Eckl, Pütgens und Walter, 1988, Seiten 79 bis 81) Umsetzverfahren wird eine Filterstufe über einen steuerbaren Schalter mit einer Referenzgröße in Form einer Referenzspannung beaufschlagt. Ein umzusetzender Digitalwert wird in einer Periode durch das Verhältnis zwischen einer Dauer eines Einschaltimpulses zu der Periodendauer (Tastverhältnis) dargestellt. Der Schalter wird entsprechend dem jeweiligen Tastverhältnis jeder Periode geöffnet und geschlossen, so daß am Ausgang der Filterstufe ein Analogwert abgreifbar ist, dessen Mittelwert dem umgesetzten Digitalwert der jeweiligen Periode entspricht.

Da der Analogwert (bei gleichbleibendem Digitalwert) zeitlich konstant sein soll, d. h. seine Restwelligkeit (Brummen) gegenüber dem Mittelwert vernachlässigbar sein soll, ist für die Filterstufe eine entsprechend große Zeitkonstante zu wählen. Damit wird jedoch die Grenzfrequenz des Digital-Umsetzverfahrens verhältnismäßig niedrig.

Der Erfindung liegt daher die Aufgabe zugrunde, ein Digital-Analog-Umsetzverfahren der eingangs angegebenen Art zu schaffen, das sich durch eine hohe Grenzfrequenz bei niedriger Restwelligkeit des Analogwertes auszeichnet.

Erfindungsgemäß wird diese Aufgabe dadurch gelöst, daß Einzelimpulse gebildet werden, die in der Summe ihrer Einzelimpulsdauern der Einschaltimpulsdauer der Periode entsprechen, und daß die Einzelimpulse annähernd gleichmäßig über die Periodendauer verteilt werden. Vorzugsweise sind Einschaltimpulsdauer und Periodendauer jeweils Vielfache einer Systemtaktdauer. Durch die Darstellung des Digitalwertes durch in ihrer Summe der gewünschten Einschaltimpulsdauer entsprechende Einzelimpulse und deren gleichmäßige Verteilung über die Periodendauer erfolgt in vorteilhafter Weise eine Vergleichmäßigung der Filterstufenbeaufschlagung mit der Referenzgröße. Die Filterstufe wird nämlich bei dem erfindungsgemäßen Umsetzverfahren - je nach gesamter Einschaltimpulsdauer jeder Periode - während jeder Periode im Vergleich zu dem bekannten Umsetzverfahren jeweils kürzer und öfter mit der Referenzgröße beaufschlagt. Zwischen den Beaufschlagungen liegt somit eine verhältnismäßig kurze Zeitspanne. Dadurch sinkt bei unveränderter Zeitkonstante die Restwelligkeit. Bei gleicher Restwelligkeit im Vergleich zu dem bekannten Umsetzverfahren kann eine Filterstufe mit einer geringeren Zeitkonstante gewählt werden, so daß sich die Grenzfrequenz erhöht. Durch die verminderte Zeitkonstante wird außerdem die Einstellzeit, d. h. die Zeit bis zum Erreichen eines konstanten Mittelwertes bei gleichbleibendem Digitalwert, erheblich verkürzt.

Eine im Hinblick auf den Aufwand zur Durchführung des erfindungsgemäßen Verfahrens vorteilhafte Fortbildung des erfindungsgemäßen Verfahrens besteht darin, daß die Einzelimpulse eine einer Systemtaktdauer entsprechende Einzelimpulsdauer aufweisen.

Gemäß einer vorteilhaften Weiterbildung des erfindungsgemäßen Verfahrens lassen sich die Einzelimpulse besonders einfach bilden, indem ein Laufwert unter der Bedingung O ≤ Laufwert < Periodendauer gewählt wird, anschließend mit jedem Systemtakt die Summe von Laufwert und der Einschaltimpulsdauer gebildet und neu als Laufwert verwendet wird und in dem Fall, daß der Laufwert größer als die oder gleich der Periodendauer ist, ein Einzelimpuls für den aktuellen Systemtakt generiert und die Differenz zwischen Laufwert und Periodendauer neu als Laufwert verwendet wird.

Eine besonders einfach aufgebaute, von einer zentralen Steuerung unabhängige und damit störungsunanfällige Vorrichtung zur Durchführung des erfindungsgemäßen Verfahrens mit einem Schalter, dessen Stellung durch das Tastverhältnis steuerbar ist und der in geschlossenem Zustand die Referenzgrößenquelle mit der Filterstufe verbindet, an der ausgangsseitig der Analogwert abgreifbar ist, weist einen digitalen Addierer auf, dessen einer Dateneingang mit einer der Einschaltdauer entsprechenden Größe beaufschlagbar ist, dessen weiterer Dateneingang mit einem Datenausgang eines systemtaktgesteuerten Speichers verbunden ist, dessen Datenausgang mit einem Dateneingang des Speichers verbunden ist und dessen Überlaufsignal den Schalter steuert.

Die Erfindung wird nachfolgend anhand einer Zeichnung näher erläutert. Es zeigen

Figur 1    ein Flußdiagramm zur Erläuterung von Schritten zur Bildung von Einzelimpulsen,

Figur 2    Zustände verschiedener Größen bei der Bildung der Einzelimpulse,

Figur 3    eine Vorrichtung zur Durchführung des erfindungsgemäßen Verfahrens und

Figur 4    die Verteilung von Einzelimpulsen bei mehreren Perioden.

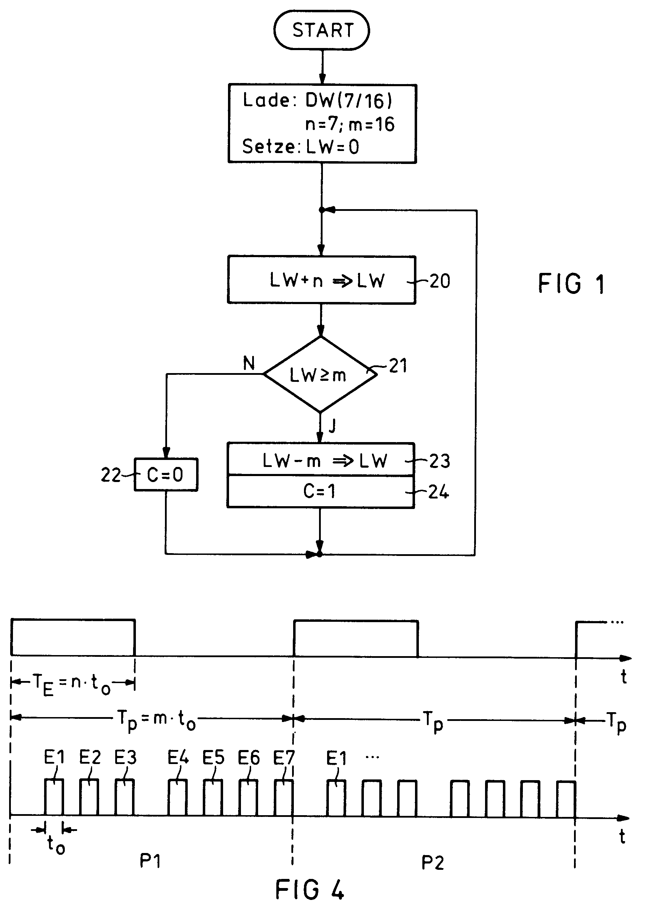

Zu Beginn des erfindungsgemäßen Verfahrens wird gemäß Figur 1 zunächst ein umzusetzender Digitalwert DW geladen. Dies kann in üblicher Form beispielsweise durch direkte Eingabe, einen Binärcode, Speicherzugriff usw. erfolgen. Die Angabe des Digitalwertes DW erfolgt jeweils durch ein eine Einschaltimpulsdauer $T_E$ (Figur 4) repräsentierendes Vielfaches n einer Systemtaktdauer $t_o$ in Bezug auf eine in einem Vielfachen m der Systemtaktdauer $t_o$ bemessene Periodendauer $T_p$ (Tastverhältnis n/m). Nachfolgend wird die der Einschaltimpulsdauer $T_E$ entsprechende Größe in Form der Vielfachen n und die der Periodendauer $T_p$ entsprechende Größe als Vielfache m angegeben. Im vorliegenden Beispiel hat die Größe n eine 4-Bit-Wertigkeit und den Wert 0111 (Dezimalwert 7). Ferner wird vorab ein Laufwert LW gewählt, der zwischen 0 und der um 1 verminderten Größe m liegt. Im vorliegenden Beispiel wird der Laufwert LW = O gewählt. Die Periodendauer beträgt $T_p$ = 16 $t_o$. Der Digitalwert DW beträgt also 7/16 (Tastverhältnis), d. h. 43,75 %.

Anschließend wird mit jedem Systemtakt CLK in einem ersten Schritt 20 die Summe von Laufwert LW und Größe n gebildet und als neuer Laufwert LW verwendet. Im vorliegenden Beispiel ergibt sich als neuer Laufwert somit der Dezimalwert 7. Anschließend erfolgt ein Vergleich des Laufwertes LW mit der Größe m in einem weiteren Schritt 21. Ist der Laufwert LW kleiner als die Größe m, wird ein Überlaufsignal C in einem Schritt 22 auf den Wert O gesetzt und der Vorgang mit Schritt 20 mit dem folgenden Systemtakt CLK begonnen. Ist der Laufwert LW größer oder gleich der Größe m (Periodendauer $T_p$), wird in einem Schritt 23 die Differenz zwischen dem Laufwert LW und der Größe m gebildet und als Laufwert LW neu verwendet; gleichzeitig wird das Überlaufsignal C auf den Wert 1 gesetzt (Schritt 24) und das Verfahren mit Schritt 20 mit dem folgenden Systemtakt CLK erneut durchlaufen.

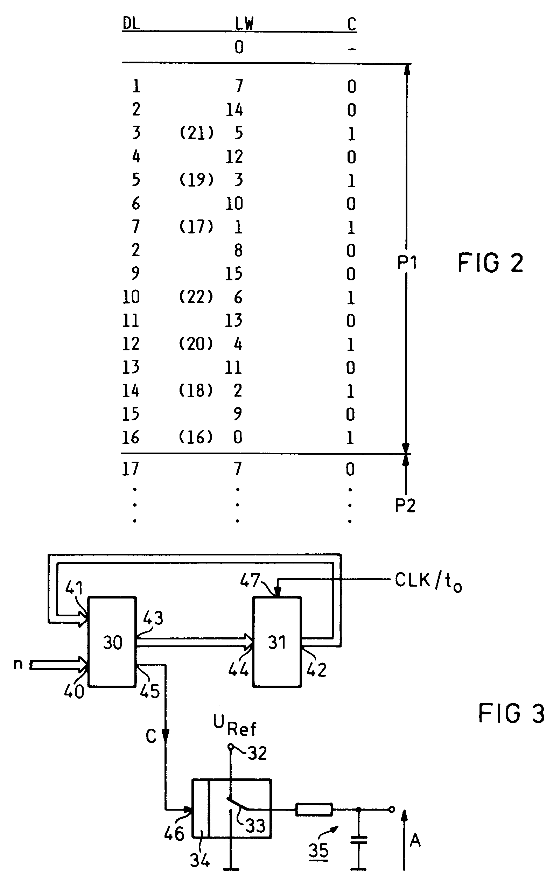

Figur 2 zeigt in 17 aufeinanderfolgenden Durchläufen DL auftretenden Werte für den Laufwert LW und das Überlaufsignal C mit den im Zusammenhang mit der Figur 1 beispielhaft gewählten Werten. Die Durchläufe DL = 1 bis 16 definieren eine erste Periode P1. Erreicht bzw. überschreitet der Laufwert LW den Wert 16 (d. h. den der Größe m) wird das Überlaufsignal in diesem Verfahrensdurchlauf auf den Wert 1 gesetzt. Dies ist erstmalig beim dritten Durchlauf DL der Fall, wobei der Laufwert LW im Schritt 20 zunächst den Wert 21 erhält und dann in Schritt 13 auf den Wert 5 neu gesetzt wird. Die jeweils in diesen Fällen zunächst gesetzten Werte für den Laufwert LW sind bei den Durchläufen DL 3, 5, 7, 10, 12, 14 und 16 jeweils in Klammern gesetzt.

Figur 3 zeigt eine Vorrichtung zur Durchführung des erfindungsgemäßen Verfahrens mit einem 4-Bit-Addierer 30, einem Speicher 31, einer Referenzspannungsquelle 32, einem Schalter 33, einer Schaltersteuerung 34 und einer Filterstufe 35. Ein 4-Bit-Dateneingang 40 des Addierers 30 ist mit der die Einschaltimpulsdauer $T_E$ repräsentierenden Größe n beaufschlagt und ein weiterer Eingang 41 des Addierers 30 ist mit einem Datenausgang 42 des 4-Bit-Speichers 31 verbunden. Ein 4-Bit-Datenausgang 43 des Addierers 30 ist auf einen Dateneingang 44 des Speichers 31 geführt. Ein Überlaufsignalausgang 45 des Addierers 30 ist auf einen Steuereingang 46 der Schaltersteuerung 34 geführt. Der Speicher 31 weist einen Übernahmetakteingang 47 auf, der mit dem Systemtakt CLK mit der Taktdauer $t_o$ beaufschlagt ist. Die in der Figur 3 gezeigte Beschaltung von Addierer 30 und Speicher 31 generiert im Zusammenspiel mit dem Systemtakt CLK die in der Figur 2 dargestellten Werte für das Überlaufsignal C an dem Überlaufsignalausgang 45 des Addierers 30. Wenn der Laufwert LW eingangs auf den Wert O gesetzt ist (vgl. Figur 1), entspricht dies einem Rücksetzen des Speichers 31; zur Voreinstellung eines anderen Laufwertes LW wird der Speicher 31 entsprechend vorgeladen. Sofern das Überlaufsignal C den Wert 1 aufweist, wird über die Schaltersteuerung 34 der Schalter 33 für die Taktdauer $t_o$ geschlossen und dementsprechend die Filterstufe 35 mit der Referenzspannung $U_{Ref}$ der Referenzspannungsquelle 32 beaufschlagt. Ausgangsseitig ist an der Filterstufe 35 ein dem Digitalwert DW entsprechender Analogwert A abgreifbar.

Figur 4 zeigt die Anordnung von Einzelimpulsen E1 bis E7 mit einer jeweiligen Einzelimpulsdauer mit der Taktdauer $t_o$.

Es sind Einzelimpulse E1 bis E7 für Perioden P1 und P2 gezeigt. Jede Periode P1 und P2 weist eine Periodendauer $T_P$ = $m.t_o$, im vorliegenden Beispiel also $T_p$ = $16.t_o$ auf. Zur Gegenüberstellung sind in der Figur 4 oben die Verhältnisse beim eingangs erwähnten, bekannten Umsetzverfahren gezeigt, wobei ein einziger Einschaltimpuls mit einer Einschaltimpulsdauer $T_E$ = $n.t_o$ = $7.t_o$ innerhalb der jeweiligen Periodendauer $T_p$ gezeigt ist. Die Summe der Einzelimpulsdauern der Einzelimpulse E1 bis E7 entspricht der Einschaltimpulsdauer $T_E$.

Die Aufteilung des Einschaltimpulses auf eine Vielzahl von Einzelimpulsen pro Periode und die gleichmäßige Verteilung der Einzelimpulse in bezug auf die Periodendauer ermöglicht eine wesentlich geringere Zeitkonstante für die Filterstufe 35 (Figur 3) zu wählen, ohne daß sich eine wesentliche Erhöhung der Restwelligkeit des auf diese Weise erzeugten und am Ausgang der Filterstufe 35 abgreifbaren Analogwertes A ergibt. Damit ist die Grenzfrequenz des Systems wesentlich erhöht.

**Patentansprüche**

1. Digital-Analog-Umsetzverfahren, bei dem ein umzusetzender Digitalwert (DW) durch ein von einer Einschaltimpulsdauer ($T_E$) einer Periode (P1) zu deren Periodendauer ($T_p$) bestimmtes Tastverhältnis (n/m) dargestellt wird, bei dem eine Filterstufe (35) gemäß dem Tastverhältnis (n/m) mit einer Referenzgröße ($U_{Ref}$) beaufschlagt wird und bei dem an deren Ausgang ein Analogwert (A) abgegriffen wird,
**dadurch gekennzeichnet,** daß Einzelimpulse (E1...E7) gebildet werden, die in der Summe ihrer Einzelimpulsdauern ($t_o$) der Einschaltimpulsdauer ($T_E$) der Periode (P1) entsprechen, und daß die Einzelimpulse (E1...E7) annähernd gleichmäßig über die Periodendauer ($T_p$) verteilt werden.

2.  Verfahren nach Anspruch 1,
    **dadurch gekennzeichnet,**
    daß die Einzelimpulse (E1...E7) eine einer Systemtaktdauer ($t_o$) entsprechende Einzelimpulsdauer aufweisen.

3.  Verfahren nach Anspruch 2,
    **gekennzeichnet durch** folgende Schritte zur Bildung der Einzelimpulse (E1...E7):
    Es wird ein Laufwert (LW) unter der Bedingung O ≤ Laufwert (LW) < Periodendauer ($T_p$) gewählt;
    anschließend wird mit jedem Systemtakt (CLK) die Summe von Laufwert (LW) und Einschaltimpulsdauer ($T_E$) gebildet und neu als Laufwert (LW) verwendet;
    in dem Fall, daß der Laufwert (LW) größer als die oder gleich der Periodendauer ($T_p$) ist, wird ein Einzelimpuls (E1...E7) für den aktuellen Systemtakt (CLK) generiert und die Differenz zwischen Laufwert (LW) und Periodendauer ($T_p$) neu als Laufwert (LW) verwendet.

4.  Vorrichtung zur Durchführung des Verfahrens nach Anspruch 3 mit einem Schalter (33), dessen Stellung durch das Tastverhältnis (n/m) steuerbar ist und der in geschlossenem Zustand die Referenzgrößenquelle ($U_{Ref}$) mit der Filterstufe (35) verbindet, an der ausgangsseitig der Analogwert (A) abgreifbar ist,
    **gekennzeichnet durch** einen digitalen Addierer (30), dessen einer Dateneingang (40) mit einer der Einschaltdauer ($T_E$) entsprechender Größe (n) beaufschlagbar ist, dessen weiterer Dateneingang (41) mit einem Datenausgang (42) eines systemtaktgesteuerten Speichers (31) verbunden ist, dessen Datenausgang (43) mit einem Dateneingang (44) des Speichers (31) verbunden ist und dessen Überlaufsignal (C) den Schalter (33) steuert.

FIG 1

FIG 4

| DL | | LW | C |
|---|---|---|---|
| | | 0 | – |
| 1 | | 7 | 0 |
| 2 | | 14 | 0 |
| 3 | (21) | 5 | 1 |
| 4 | | 12 | 0 |
| 5 | (19) | 3 | 1 |
| 6 | | 10 | 0 |
| 7 | (17) | 1 | 1 |
| 2 | | 8 | 0 |
| 9 | | 15 | 0 |
| 10 | (22) | 6 | 1 |
| 11 | | 13 | 0 |
| 12 | (20) | 4 | 1 |
| 13 | | 11 | 0 |
| 14 | (18) | 2 | 1 |
| 15 | | 9 | 0 |
| 16 | (16) | 0 | 1 |
| 17 | | 7 | 0 |
| . | | . | . |
| . | | . | . |
| . | | . | . |

P1

P2

FIG 2

FIG 3